# EUROPEAN PATENT SPECIFICATION

(11) **EP 2 214 462 B1**
(45) Date of publication and mention of the grant of the patent: **19.09.2012**
(21) Application number: 10000885.3
(22) Date of filing: 28.01.2010
(51) Int. Cl.: H05K 5/02, H04N 5/64, H05K 7/20, H05K 9/00

(54) **Display apparatus and display system**
Anzeigevorrichtung und Anzeigesystem
Appareil d'affichage et système d'affichage

(30) Priority: 30.01.2009 JP 2009020349; 30.01.2009 JP 2009020350; 30.01.2009 JP 2009020351; 30.01.2009 JP 2009020352; 30.01.2009 JP 2009020353
(43) Date of publication of application: 04.08.2010
(73) Proprietor: SANYO Electric Co., Ltd., Moriguchi-shi Osaka 570-8677 (JP)
(72) Inventor: Nakamichi, Masaya, Moriguchi-shi, Osaka (JP); Take, Nobuyuki, Moriguchi-shi, Osaka (JP); Takahashi, Shohei, Moriguchi-shi, Osaka (JP)
(74) Representative: Glawe, Delfs, Moll

(56) References cited:
- WO-A1-2009/147897

## Description

### BACKGROUND OF THE INVENTION

### 1. Field of the Invention

The present invention relates to a display system, especially, a display system for installation outdoors according to the preamble of claim 1.

### 2. Description of Related Art

Conventionally, plane surface type displays, such as liquid crystal displays (LCDs), are widely used. A display system of the art is for example known from WO 2009/147897 A1.

Recently, it has been desired to place liquid crystal displays permanently outdoors, because the thickness of the displays are small and can display high resolution pictures. Since the thickness of the LCD display is small, it can be installed on an outer wall of a building, or in narrow places such as bus stop shelters, etc. Moreover, because the resolution of a LCD display is high, it can display a clear picture even if the screen size is small.

Therefore, in order to install a liquid crystal display outdoors, a display unit arranging a liquid crystal display panel inside the accommodation part having a sealed structure is considered. However, in the outdoors, vibrations caused by vehicles passing through the display unit may damage the display unit.

### SUMMARY OF THE INVENTION

According to the invention, there is provided a display system according to claim 1.

A first display apparatus may be used and may comprise: a display part; a light transmitting part arranged at the front side of the display part, wherein the light transmitting part comprises: a pair of light transmitting boards, and a light absorbing film inserted between the boards absorbing an infrared.

A second display apparatus may be used and may comprise: a display part; a cooling device cooling the display part; a light detector detecting a light entering the display part, and a control part which operates the cooling device when the light detected by the light detector is larger than a predetermined value, and stops the cooling device when the light detected by the light detector is smaller than the predetermined value.

A third display apparatus may be used and may comprise: a display part; an electric circuit controlling the display part; an accommodation part arranged at the back side of the display part and accommodates the electric circuit; an upper part cover component constituting the back wall of the accommodation part; a lower part cover component constituting the back wall of an accommodation part. The upper part cover component comprises: a first penetration hole made to pass the leg of a screw but not the head of the screw, and a second penetration hole connected with the first penetration hole and passes both the leg and head of the screw.

### BRIEF DESCRIPTION OF THE DRAWINGS

FIG.1 is a perspective diagram showing the display system having a display apparatus.
FIG.2 is an exploded perspective view of a display system.
FIG.3 is a sectional view along the IV-IV line shown in FIG.2.
FIG.4 is a sectional view along the V-V line shown in FIG.3.
FIG.5 is a sectional view along the VI-VI line shown in FIG.3.
FIG.6 is a sectional view along the VII-VII line shown in FIG.3.
FIG.7 is a two-dimensional diagram of this display system.
FIG.8 is an enlarged view of IX area shown in FIG.4.
FIG.9 is the perspective diagram when fractured along X-X-rays shown in FIG.3.
FIG.10 is the perspective diagram when fractured along XI-XI line shown in FIG.3.
FIG.11 is a sectional view along the XI-XI line shown in FIG.3.
FIG.12 is an enlarged view of the XIII area shown in FIG.11.
FIG.13 is an enlarged view of the XIV area shown in FIG.11.
Fig.14 is a perspective diagram of the back side of the display apparatus when a cover component is attached.
Fig.15 is a perspective diagram of the back side of the display apparatus when a cover component is detached.
Fig.16 is a perspective diagram of the back wall of the first accommodation part when a cover component is attached, viewed from the back lower side.
Fig.17 is a perspective diagram of the back wall of the first accommodation part when a cover component is detached, viewed from the back lower side.
Fig.18 is a perspective diagram showing the state before attaching the display apparatus to a support stand.

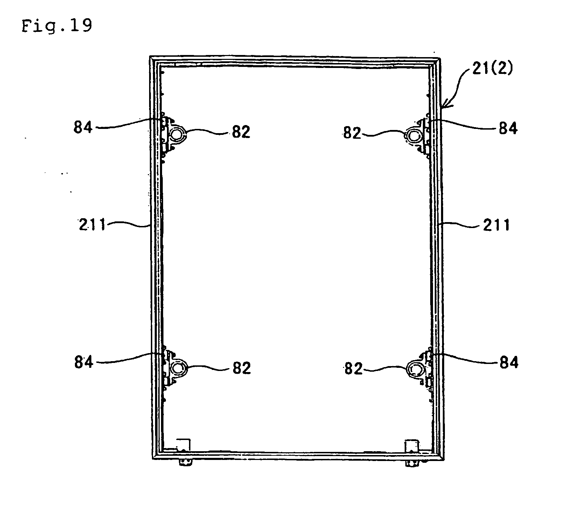

FIG.19 is a two-dimensional diagram showing the frame part of a support stand.

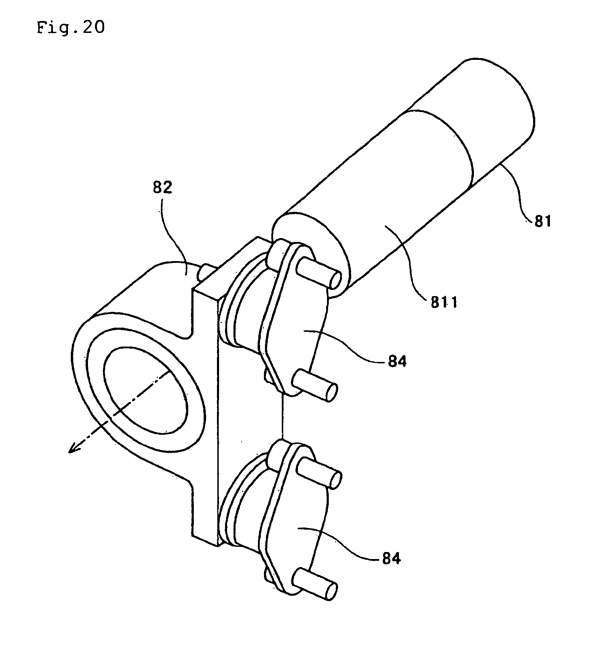

FIG.20 is a perspective diagram showing a first state of the engaging component and the engaged component, when attaching a display apparatus to a support stand.
FIG.21 is a perspective diagram showing a second state of the engaging component and the engaged component, when attaching a display apparatus to a support stand.
FIG.22 is a perspective diagram showing a third state of the engaging component and the engaged component, when attaching a display apparatus to a support stand.
Fig.23 is a two-dimensional diagram showing the lower part cover part of the cover component.
Fig.24 is an enlargement of an area A shown in Fig.23.
Fig.25 (a) is two-dimensional diagram and (b) is perspective diagram showing a state where a lower cover part is arranged in the first position.
Fig.26 (a) is two-dimensional diagram and (b) is perspective diagram showing a state where a lower cover part is arranged in the second position.
Fig.27 is a perspective diagram showing a preventing component fixed to the engaging component.
Fig.28 is a perspective diagram showing a preventing component fixed to the engaging component, when viewed from a different direction from Fig.27.
Fig.29 is a perspective diagram showing a display fixed to the frame part of a support stand.
Fig.30 is a perspective diagram showing a back wall of the first accommodation part viewed from its back side when plurality of cables are pulled out.
Fig.31 is a perspective diagram showing a back wall of the first accommodation part viewed from its back side when plurality of cables are removed.
Fig.32 is a sectional view showing a light transmitting part formed in the front wall.
Fig.33 is a block diagram showing an air conditioner, a control means, and a light detector equipped in a display apparatus.
Fig.34 is a front view of a display system.
Fig.35 is a sectional view along the B-B line shown in Fig.34.
Fig.36 is a sectional view along the C-C line shown in Fig.34.
Fig.37 is a sectional view along the E-E line shown in Fig.34.
Fig.38 is a figure showing the relation between the light detected by a light detector, and the temperature of the display panel.

### DETAILED DESCRIPTION OF THE INVENTION

The present invention embodied in a display apparatus or display system will be specifically described below with the reference to the drawings.

### 1. Overview of the display system

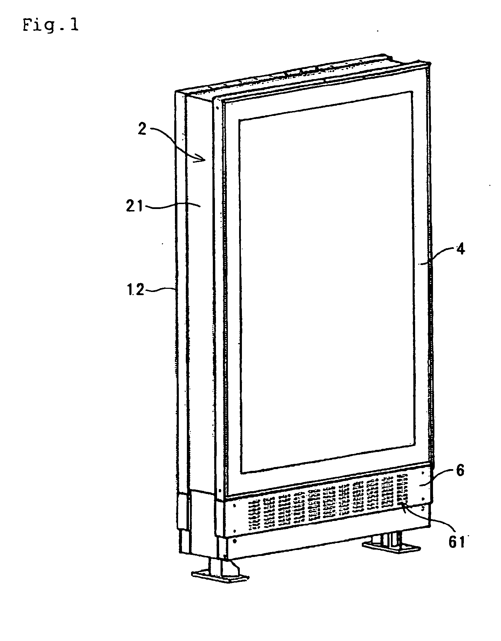

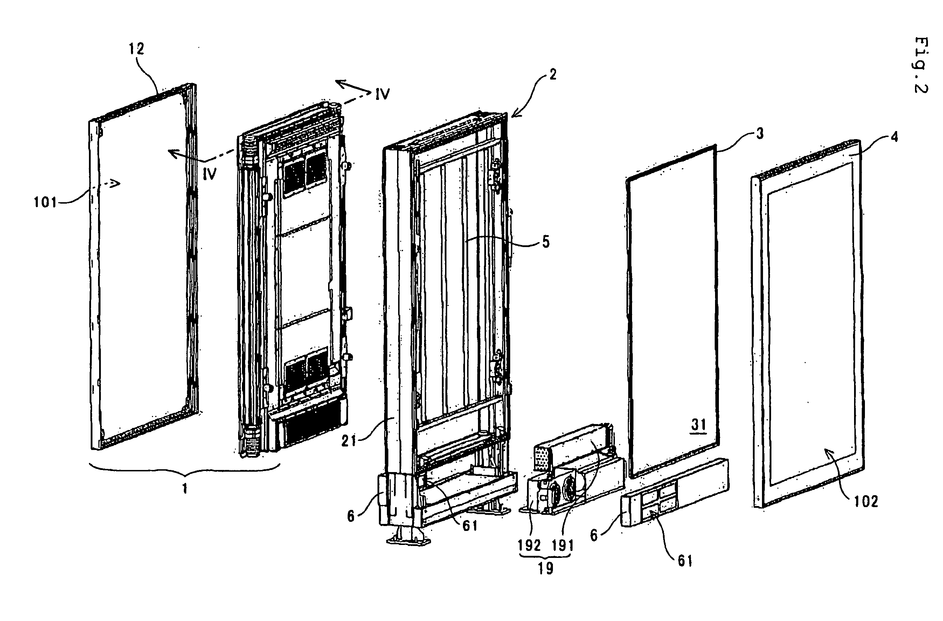

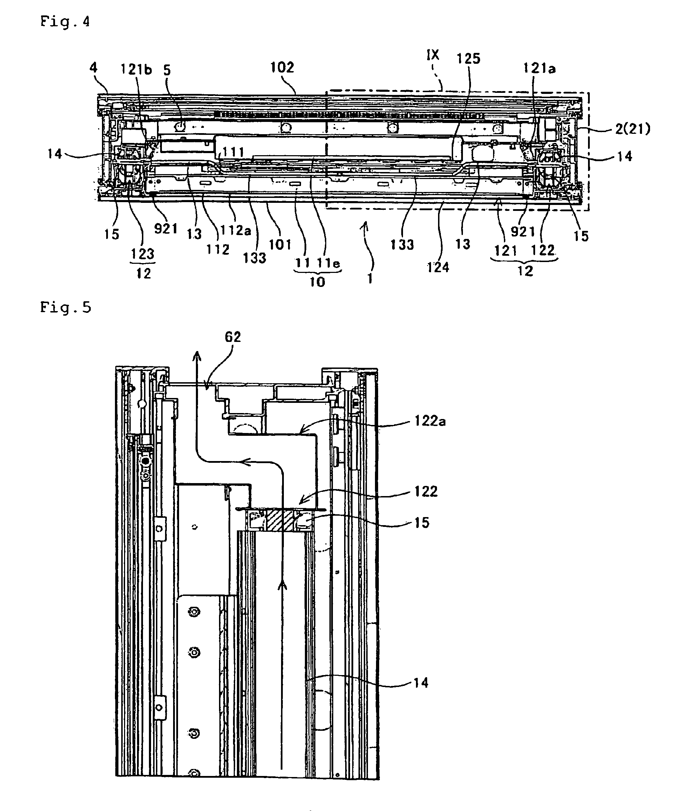

As shown in FIG.1 the display system has a flat rectangular appearance, and as shown in FIG.2, it includes a display apparatus 1, support stand 2, backboard 3, cover 4, fluorescent light fittings 5, and pair of aeration plates 6, 6. The display apparatus 1 displays an image on the surface 101 of the display system, and has a liquid crystal display 10 as shown in FIG.5. The detail of the display apparatus 1 is explained below in section 2 entitled "A display apparatus".

The support stand 2 supports the display apparatus 1 and the backboard 3, and a frame part 21 for attaching the display apparatus 1 and the backboard 3 is formed. The frame part 21 has a structure that can contain the display apparatus 1 and the backboard 3. The structure for attaching the display apparatus 1 to the support stand 2 is explained below in section 3 entitled "Composition for attaching a display apparatus to a support stand".

The backboard 3 is an installation stand for attaching an advertisement, and is installed in the frame part 21 at the back side of the display apparatus 1. The advertisement is attached on the surface 31 of the backboard 3, which is a back surface 102 of a display system. Here, the backboard 3 is formed from a material having an optical transparency in order to transmit a light emitted from the fluorescent light fittings 5. The advertisement attached to the backboard 3 is also formed from a material having an optical transparency as well. Hereafter, such advertisement is called "advertising film".

The cover 4 is removably attached to the support stand 2, and it covers the surface 31 of backboard 3 when it is closed. Thereby, the advertisements can be protected by the cover 4. The portion which faces the surface 31 among the covers 4 is formed with a material having an optical transparency. Thereby, the advertisement can be seen from the back side 102 of the display system.

The fluorescent light fitting 5 is an instrument which illuminates the advertising film attached on the surface 31, and is constituted by a plurality of fluorescent lights extending in the perpendicular direction. The fluorescent light fitting 5 is attached to the frame part 21 between the display apparatus 1 and the backboard 3. By illuminating an advertising film with the fluorescent light fittings 5, characters printed on the advertising film can be seen even at nighttime.

A pair of aeration plates 6, 6 are arranged at the front 101 and the back 102 of the display system respectively, at the bottom part of the display apparatus 1. A plurality of vents 61, which aerate the inside and the outside of the display system are formed in the aeration plates 6.

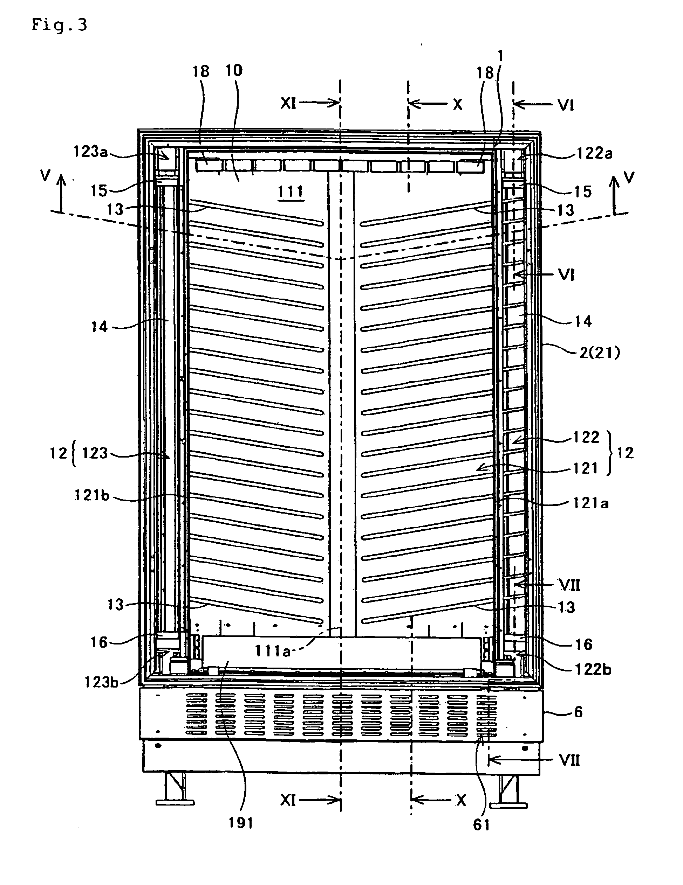

The display system mentioned above can be installed in a bus stop or similar waiting area of public transportation systems, as shown in FIG.3. According to this system, it can offer many kinds of information to the people waiting at the stop using still pictures or moving animations.

By operating a display system by remote control using a cable or a wireless communication system, information displayed on the screen 112a can be updated remotely. Furthermore, when display systems are installed in each of multiple bus stops of a transportation system, those display systems can be managed collectively.

### 2. Display apparatus

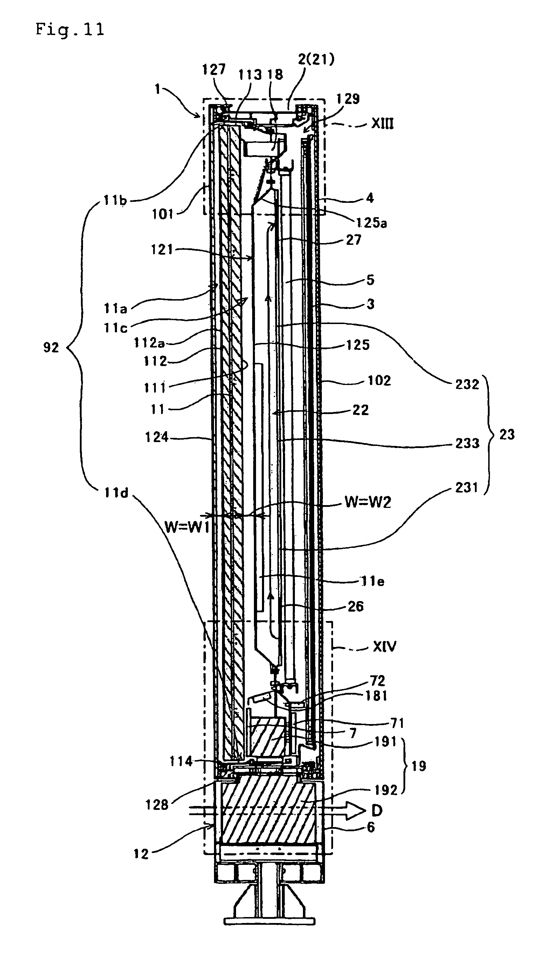

As shown in FIG.3 and FIG.4, the display apparatus 1 has a liquid crystal display 10, a housing 12, a plurality of heat pipes 13, a circulation fan 18, a radiating fin 14, aeration fans 15 and 16, and a heat collecting fin 17. Furthermore, as shown in FIG.11, the display apparatus 1 also has an air conditioner 19, a circulation fan 181, a heat insulating component 7, and heat collecting fin 71, first blowing fan 72, and second blowing fan 73.

### Liquid crystal display 10

The liquid crystal display 10 is a plane surface type display, and as shown in FIG.5, it has a display panel 11, and a circuit board 11e for controlling the display panel 11.

Depending upon its usage, various forms of display panel 11 can be used. In this embodiment, the display panel 11 has a rectangular shape extending in the vertical direction so that it can be installed in narrow places such as bus stops. Further, the display panel 11 tends have a high temperature, because it tends to generate heat especially on the surface 112 where the display screen 112a is formed.

### Housing 12

### Accommodation part

As shown in Fig.11, inside the housing 12, a first accommodation part 121 maintained sealed or substantially sealed, and the second accommodation part 22, located in the back side of the back wall 125 of the first accommodation part 121, are formed. While the display panel 11 is arranged inside the first accommodation part 121 so that the display screen 112a turns to the front side 101 of the display apparatus, the circuit board 11e is arranged inside the second accommodation part 22, in the back side of the back wall 125.

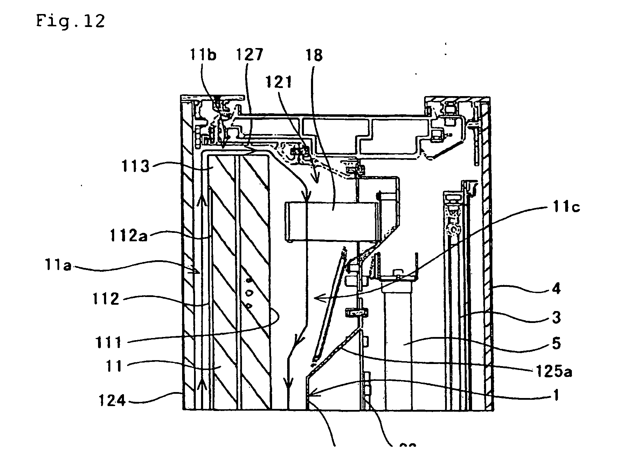

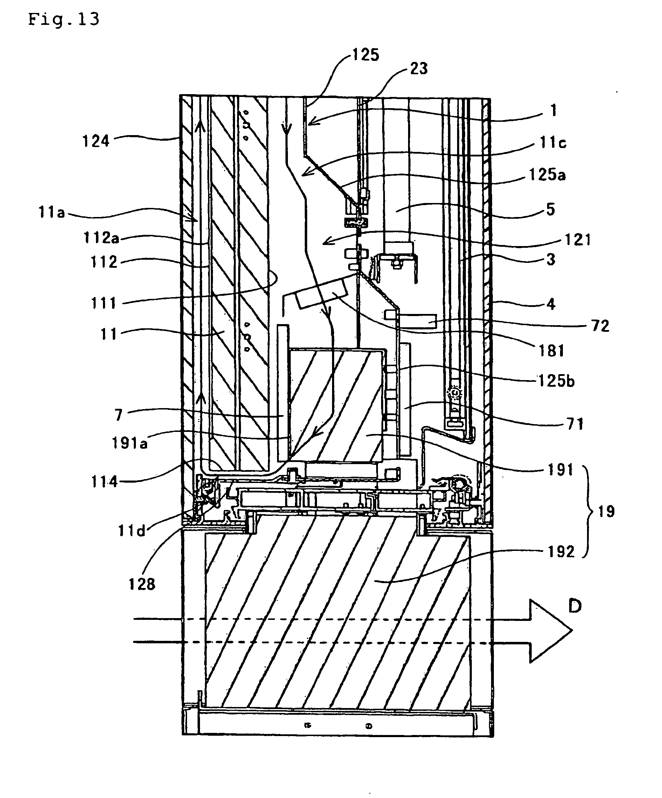

As shown in Fig.3 and Fig.11, the housing 12 has a front wall 124 on the surface 112 side of the display panel 11, a back wall 125 on the back side 111 of the panel 11, side walls 121a and 121b on the both sides of the panel 11, an upper surface wall 127 on the upper end side 113 of the panel 11 (see FIG.12 as well), and an undersurface wall 128 on the bottom side 114 of the panel 11 (see FIG.13 as well).

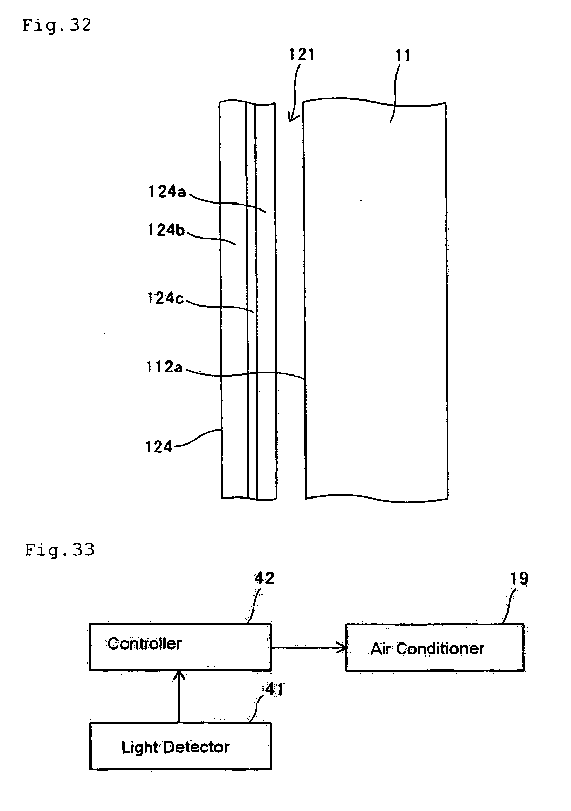

A front wall 124 has a light transmitting part, in a part where it faces the display screen 112a. As shown in Fig.32, the light transmitting part has a first light transmitting board 124a countering the front side of the display screen 112a, a second light transmitting board 124b overlapping the front side of the board 124a, and the light absorbing film 124c sandwiched by the boards 124a and 124b.

The light transmitting boards 124a and 124b are formed by a material having a light transmittance such as a glass material. For example, glass material having 4 mm and 6 mm thick are used for light transmitting boards 124a and 124b respectively. Thereby, the strength of the light transmitting part is raised. Moreover, film which absorbs far-infrared rays is used for the light absorbing film 124c.

By forming a light transmitting part in the front wall 124, the display screen 112a is viewable from the front side of the housing 12.

According to the above-mentioned light transmitting part, it can reduce sunlight from reaching the display screen 112a, since the light absorbing film 124c absorbs a far-infrared rays. Therefore, the temperature rise in the display screen 112a is suppressed. Moreover, the visibility of the display screen 112a improves when a direct sunlight is incident.

Further, since the light absorbing film 124c is sandwiched by two light transmitting boards 124a and 124b, degradation of the film 124c is prevented.

Instead of sandwiching the light absorbing film 124c by light transmitting boards 124a and 124b, the film 124c may be simply attached to a front side or back side of the first light transmitting board 124a. Even in this case, it can prevent sunlight from reaching the display screen 112a, since the sunlight entering the front wall 124 is absorbed by the film 124c.

As shown in Fig.3 and Fig.11, the first accommodation part 121 maintained in a sealed or substantially sealed state, is formed by the front wall 124, the back wall 125, the side walls 121a and 121b, the upper surface wall 127, and undersurface wall 128.

By maintaining the first accommodation part 121 in a sealed state, and by accommodating the display panel 11 inside the first accommodation part 121, the display panel 11 can be protected from rain, dust, debris, snow, etc. even when the display apparatus 1 is installed outdoors.

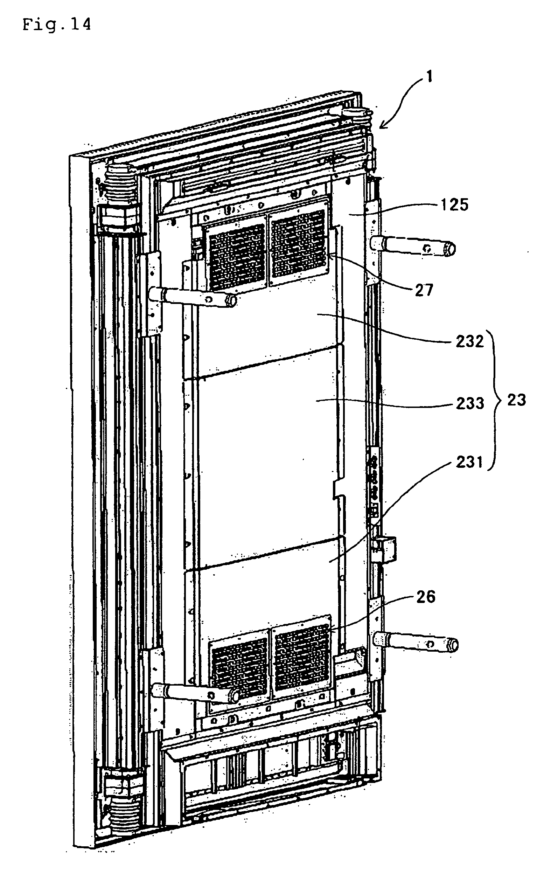

As shown in Fig.11, a concave portion 125a is formed in the back of the back wall 125, and the cover component 23 covering the concave portion 125a is attached removably in front of the fluorescent light fittings 5 and the backboard 3. In the cover component 23, a pair of ventilation openings 26 and 27 is formed as shown in Fig.11 and Fig.14. The opening 26 is arranged in the lower part, and the opening 27 is arranged in the upper part.

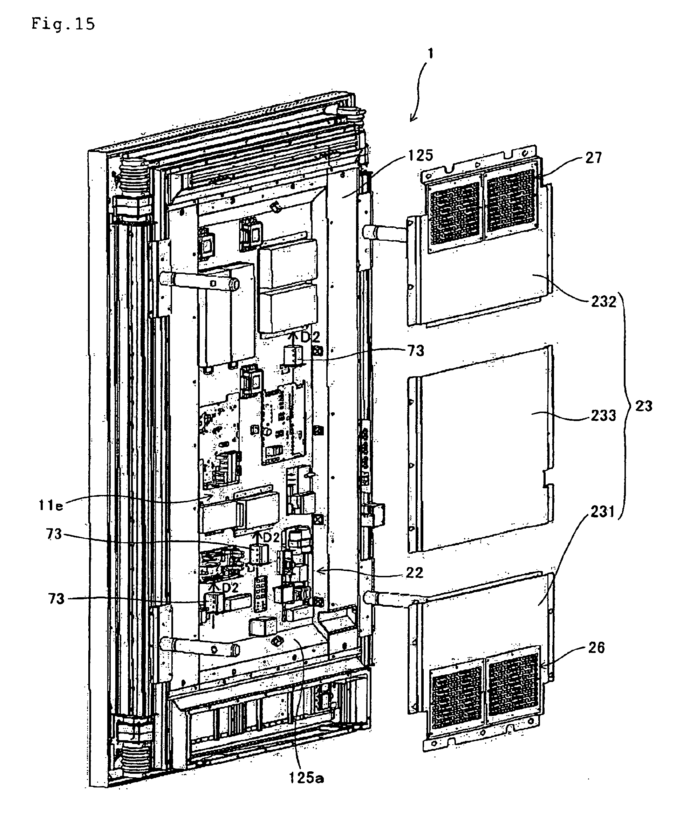

As shown in Fig.15, the cover component 23 is constituted by a lower cover 231 covering the lower part space of the concave portion 125a, the upper cover 232 covering the upper part space of the concave portion 125a, and the middle cover 233 covering the space between the upper and lower part space. In the lower cover 231, a ventilation opening 26 is formed, and in the upper cover, the other ventilation opening 27 is formed.

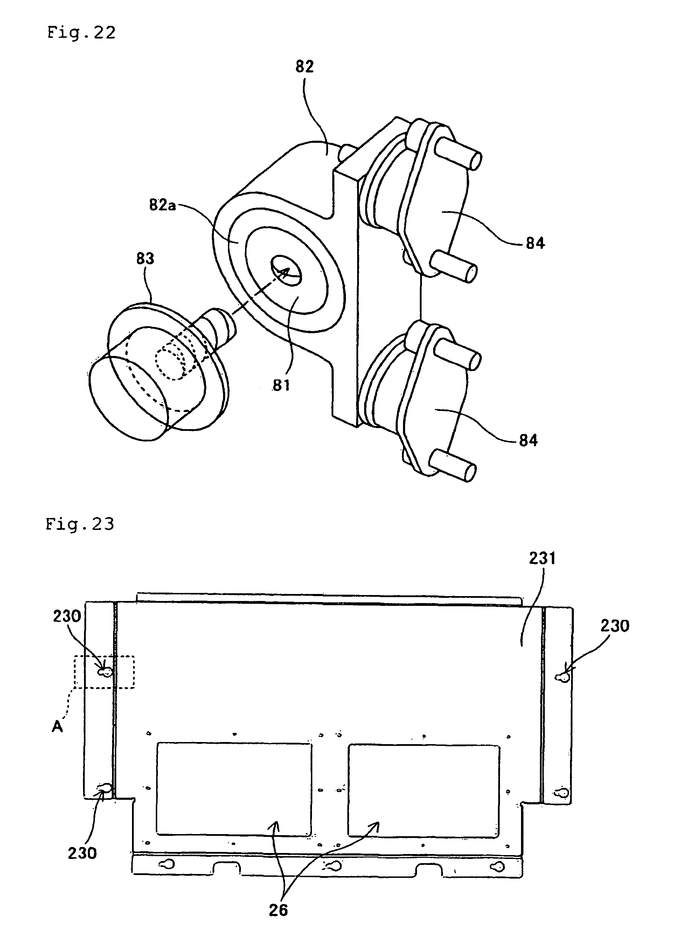

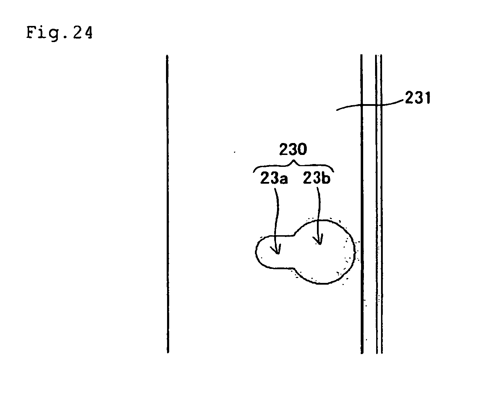

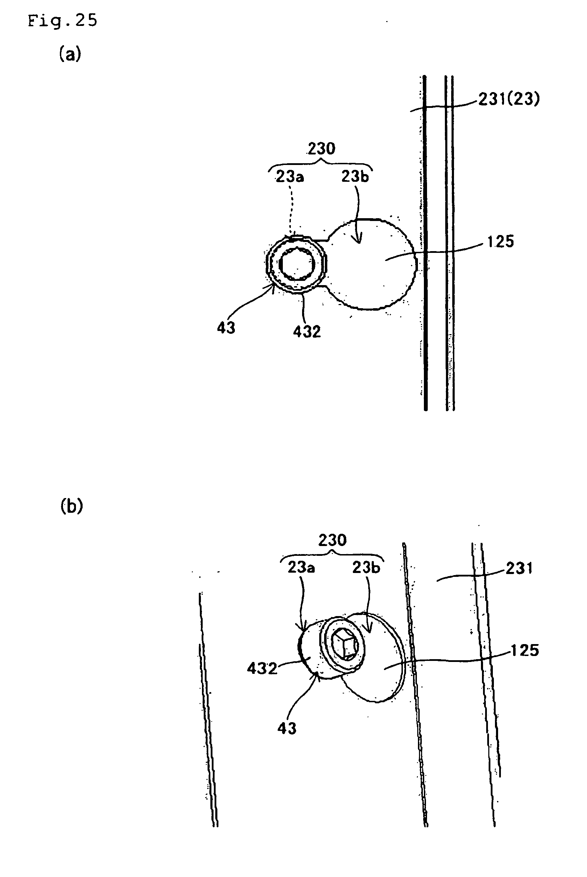

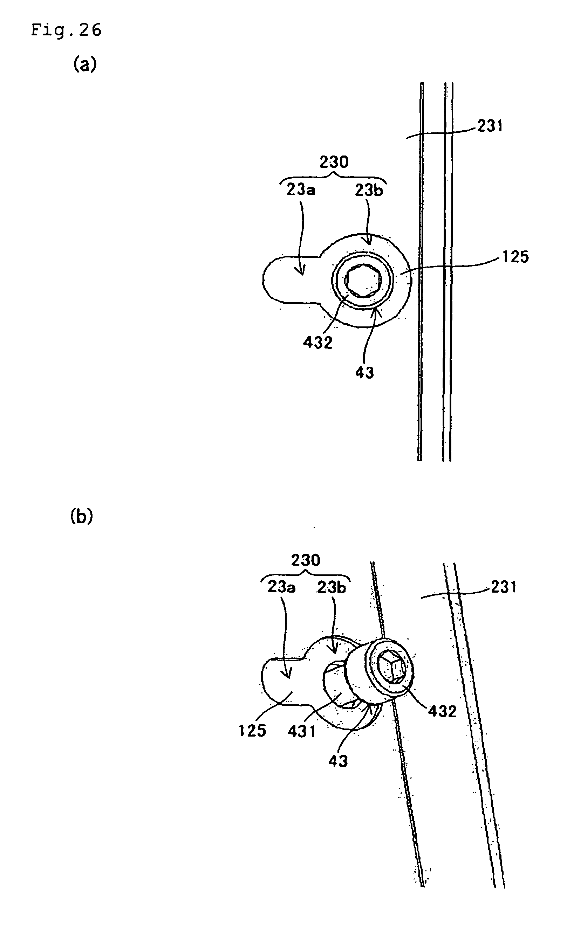

Each of the cover parts 231, 232, 233 is screwed removable on the back of the back wall 125. Fig.23 is a two-dimensional diagram showing the lower cover 231. In the cover 231, a plurality of screw penetration holes 230 for passing a screw when screwing the cover 231 to the back wall 125 are formed. As shown in Fig.24, each of the holes 230 is constituted by a first penetration hole 23a and second penetration hole 23b communicating each other. As shown in Fig.25 (a) and Fig.25 (b), the first penetration hole 23a penetrates the leg 431 of screw 43, while it does not penetrate a head 432 of the screw 43 (since the leg 431 is hidden by the lower cover 231 in Fig.25, see Fig.26(b) also). The second penetration hole 23b passes both leg 431 and head 432 of the screw 43, as shown in Fig.26 (a) and Fig.26 (b).

Since the first penetration hole 23a and the second penetration hole 23b are communicated, the lower cover 231 can slide between a first position where the leg 431 of the screw 43 penetrates the hole 23a (see Fig.25 (a)), and a second position where the leg 431 penetrates the hole 23b (see Fig.26 (a)).

When the lower cover 231 is attached to the back wall 125, the cover 231 is screwed in a state where the leg 431 of the screw 43 is penetrating the first penetration hole 23a as shown in Fig.25 (a). When removing the cover 231 from this state, the screw 43 is loosened first and then the cover 231 is slide from the first position to the second position. By moving the cover 231 backward in the second position, the head 432 of the screw 43 passes the second penetration hole 23b, and thus the cover 231 can be seceded from the back wall 125.

Therefore, by simply loosening the screw 43 without detaching the screw 43 from the back wall 125, the lower cover 231 can be removed from the back wall 125. Further, during the attaching and detaching process as mentioned above, since the screw 43 remains attached to the back wall 125, the cover 231 can be hooked to the screw 43, and thus it can prevent the cover 231 from falling down.

On the other hand, in order to attach the lower cover 231 to the back wall 125, it can be done inversely from the detaching process as described above. Therefore, the lower cover 231 can be attached to the back wall 125 while the screw 43 remained attached to the back wall 125.

The same applies to the attaching and detaching of the upper cover 232 and the central cover 233, since they have a plurality of screw penetration holes 230 consisted by the penetration holes 23a and 23b as well as the lower cover 231.

Thus, the attaching and detaching of the cover component 23 (i.e. covers 231, 232, and 233) is eased.

By attaching the cover component 23 to the back wall 125, the concave portion 125a of the back wall 125 is closed by the cover component 23, and thus the second accommodation part 22 surrounded by the inner wall and the cover component 23 of the concave portion 125a is formed. In other words the front and the side wall of the second accommodation part 22 is constituted by the inner wall of the portion 125a, and the back wall of the accommodation part 22 is constituted by the cover component.

Thus, the circuit board 11e, which is arranged at an inner space of the concave portion 125a, is accommodated inside the second accommodation part 22. Thereby, the circuit board 11e arranged inside the accommodation part 22 will not be exposed to rainstorms or outside air when the display apparatus 1 is installed outdoors. Moreover, by arranging the circuit board 11e inside the second accommodation part 22, separately from the first accommodation part 121 for the display panel 11, the circuit board 11e will not be affected by a heat from the display panel 11. Accordingly, the circuit board 11e is less likely to be damaged.

By detaching the cover component 23, the back wall of the second accommodation room 22 is removed, and thereby the repairing or adjustment of the circuit board 11e can be done easily from back side of the case. Further, since attaching and detaching of the cover component 23 can be easily performed, the repairing or adjustment can be performed easily.

Instead of forming the screw penetration hole 230 consisted by the first and the second penetration holes 23a and 23b in all of the cover parts 231, 232, 233, the screw penetration hole 230 may be formed only in the upper cover 231. Since the upper part cover component 231 is arranged in a higher position, a difficulty may follow when removing it, but by the penetration hole 230, it can prevent the upper cover 232 from falling off when attaching or removing.

Further, when the concave portion 125a is covered by the cover component 23, the portion 125b (which is also a portion of the back wall 125) formed under the concave portion 125a, and the cover component 23 are aligned in the perpendicular direction, as shown in Fig.11 and Fig.13.

### Second concave portion

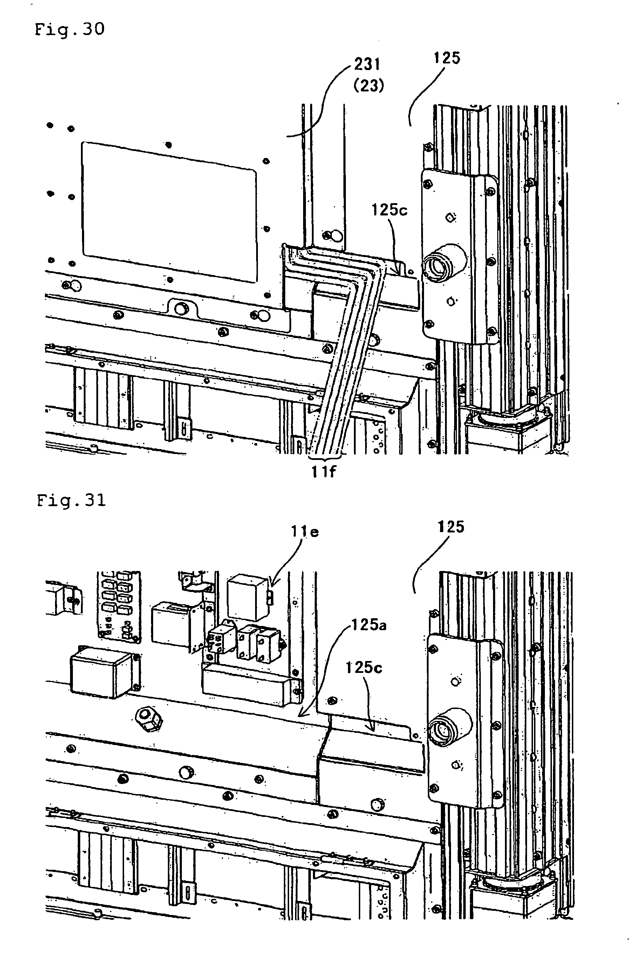

As shown in Fig.31, at the back of the back wall 125, a second concave portion 125c, which is different from the concave portion 125a, is further formed, and inner space of portions 125a and 125c are communicated each other.

To the circuit board 11e accommodated in the inner space of the concave portion 125a, a plurality of cables 11f are connected. These cables 11f run through the inner space of the concave portion 125c as shown in Fig.30. Accordingly, the cables 11f are pulled out of the housing 12. The cables 11f are for example, cables for power supplies of the display panel 11, air conditioner 19 or fans, or a cable for communications.

When pulling out the cables 11f outside the housing 12, it is desirable to bundle these cables 11f into one inside the housing 12 so that the connection with an external power supply or other apparatus become easy. Even if these cables are bundled inside the housing 12 to make a thick bundle, since the bundle can be accommodated in the space inside the second concave portion 125c, the extra space is not needed, and thus it can prevent the display apparatus 1 from growing in size.

Further, since the cover component 23 is removable from the back of the back wall 125, the cables 11f can be accommodated in a space inside the portion 125c in a state where the cover 23 is detached. Therefore, it can simplify the operation for passing the cables 11f inside the portion 125c.

### Back Cover 4

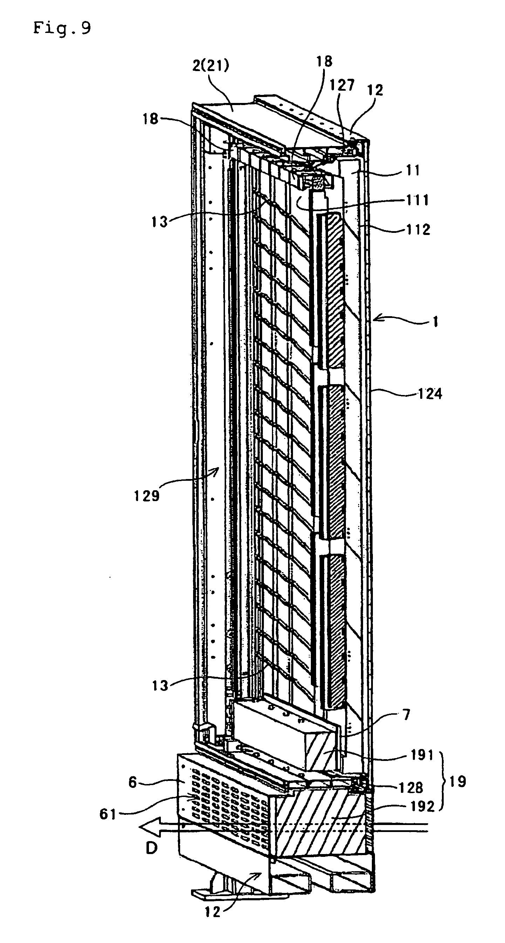

As shown in Fig.9 and Fig.11, an opening 129, which can be opened and closed by the back cover 4, is formed in the back side of the housing 12. Thereby, the advertisements installed in the backboard 3 can be easily replaced.

Although the outdoor air might intrude inside the housing 12 when the back cover 4 is opened for replacing the advertisement, display panel 11 and the circuit board 11e are less likely to be exposed to the outdoor air because they are arranged inside the accommodation parts 121 and 22. Thus, the damaging of the panel 11 and the circuit board 11e are prevented.

### Circulation path

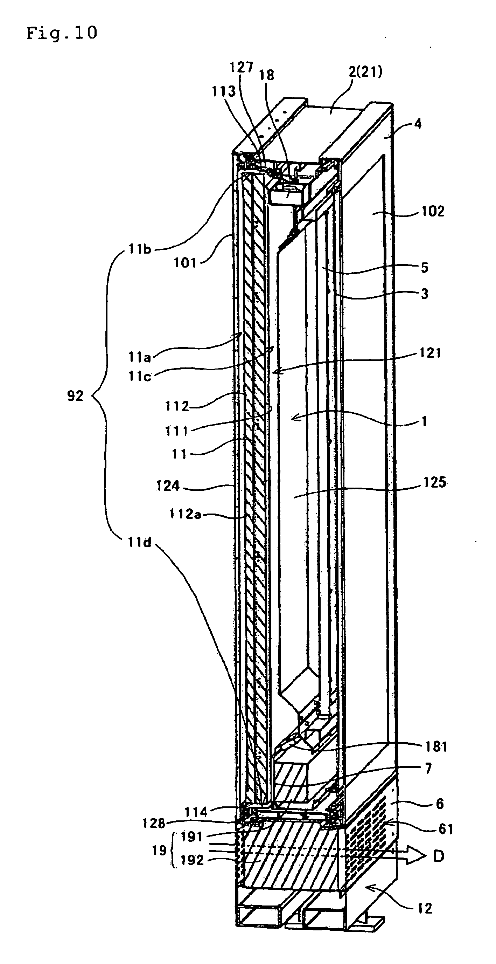

As shown in FIG.10 and FIG.11, the circulation path 92 surrounding the display panel 11 is formed inside the accommodation part 121. In FIG.10 and FIG.11, in order to clearly show the circulation path 92, an illustration of the heat pipes 13 and the heat collecting fins 17 is omitted (as in FIG.12 and FIG.13 as well, mentioned afterwards).

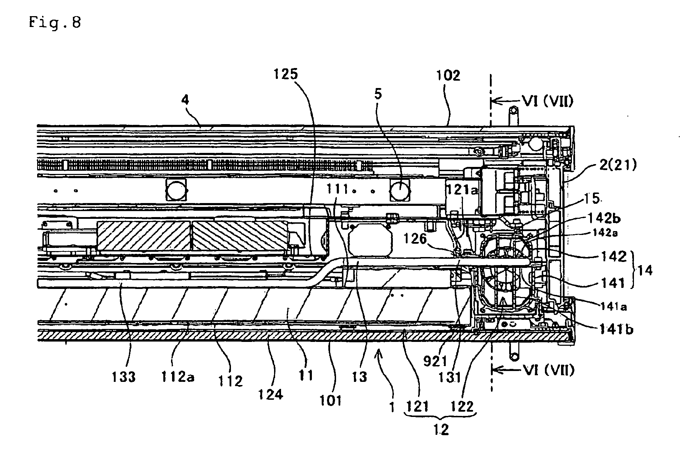

In this embodiment, a circulation path 92 is constituted by four path parts 11a to 11d. The path part 11a is formed between the surface wall 124 of the accommodation part 121, and the surface 112 of the display panel 11, and is extended along the surface 112 in a perpendicular direction. In detail, a pair of path formation components 921, 921 for forming the path part 11a is arranged on the surface 112 as shown in Fig.4. The pair of path formation components 921, 921 is extended along the surface 112 in a perpendicular direction and is intervened by the surface wall 124 and the surface 112 on both sides of the display screen 112a (see FIG.8). Thus, the path part 11a is formed, surrounded by the components 921,921, the surface wall 124, and the surface 112.

Additionally, as shown in FIG.12, a path part 11b is formed between the upper surface wall 127 of the accommodation part 121, and the upper end side 113 of the display panel 11. The path part 11c is formed between the back wall 125 and the back 111, and is extended along the back 111 in the perpendicular direction. The path part 11d is formed between the undersurface wall 128 and the lower end side as shown in FIG.13.

In this embodiment, the width W of the path part 11a (in the direction perpendicular to the outer surface of the display panel 11, see FIG.11) is smaller than that of the path part 11c. For example, the width W of the path part 11a is about 10 mm. Similarly, width W of the path parts 11b and 11d are about 10 mm.

The path parts 11a, 11b, 11c, 11d are annularly connected in order around the display panel 11, and surround the display panel 11. In other words, the path part 11a and the path part 11c are connected via path part 11b or path part 11d in the upper part or lower part respectively. The air in the circulation path 92 circulates through the surroundings of the display panel 11 by circulation fans 18 and 181 mentioned later. Therefore, the heat generated in the display screen 112a moves to the back 111 side.

### Aeration way

Inside the housing 12, the aeration ways 122 and 123 leading to the outside of the housing 12 is formed outside of the accommodation part 121. As shown in FIG.3, the aeration way 122 stretches along the side wall 121a, which is one side wall of the accommodation part 121 in the perpendicular direction, and the aeration way 123 stretches along the side wall 121b, a side wall of the another side. Hence, by forming the aeration ways 122 and 123 in both sides of the accommodation part 121, it can prevent the thickness of a display apparatus 1 being large.

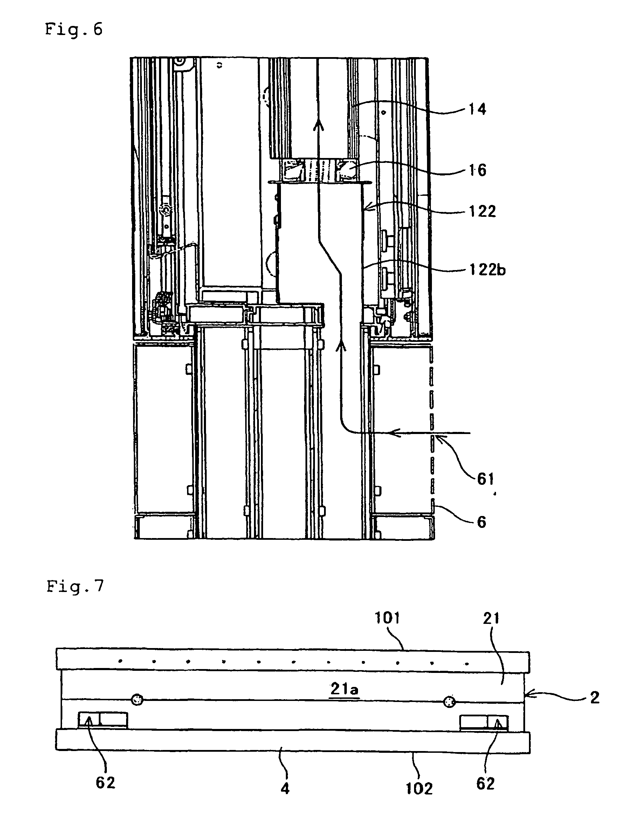

The upper end 122a of the aeration way 122 is bent in a cranked shape as shown in FIG.5, and it leads to the outside of the housing 12 through the vent 62 (see FIG.7) provided in the upper surface 21a of the frame part 21 of the support stand 2. It is as well for the upper end 123a of the aeration way 123. As shown in FIG.6, the lower end part 122b of the aeration way 122 leads to the outside of the housing 12 through the vent 61 of the aeration plates 6 which is installed under the display apparatus 1. The same applies to the lower end part 123b of the aeration way 123.

### Heat pipe 13

A plurality of heat pipes 13 are arranged in the path part 11c of the circulation path 92. As shown in FIG.3, a plurality of heat pipes 13 are fixed to the back 111, in a predetermined interval to perpendicular direction. In this embodiment, such heat pipes 13 are arranged on the both sides of the central line 111a of the back 111 in pairs.

As shown in FIG.8, a heat pipe 13 arranged at the aeration way 122 side of the central line 111a is extended from the back 111 of the display panel 11 to the aeration way 122, and penetrates a side wall 121a of the accommodation part 121, and is extended to the outside of the accommodation part 121. In detail, the heat pipe 13 is extended from the inside of the accommodation part 121 to the inside of the aeration way 122. In other words, the heat pipe 13 is arranged, protruding to the aeration way 122.

In detail, as shown in FIG.8, the penetration hole 126 is formed in the side wall 121a of the accommodation part 121, and the heat pipe 13 is stretched from the inside of the accommodation part 121 to the inside of the aeration way 122 via the penetration hole 126.

The heat pipe 13 arranged at the aeration way 123 side of the central line 111a stretches to the inside of the aeration way 123 from the inside of the accommodation part 121 (see FIG.4) via side wall 121b as well as a heat pipe 13 extended to the aeration way 122.

Further, as shown in Fig.8, the heat pipe 13 is thermally connected to the display panel 11, by contacting the back 111 of the panel 11, or via a heat conduction component. A part of the heat pipe 13, which does not contact to the panel 2, is covered by an insulation cover 133.

Thereby, heat from the display panel 11 can be collected directly from the back 111. Further, by covering the heat pipe 13 by the insulation cover 133, transmission of the heat of the heat pipe 13 to the air inside the accommodation part 121 is inhibited. Accordingly, the heat collected from the back 111 is efficiently transmitted outside the first accommodation part 121.

The heat emitted into the aeration way 122 and 123 from the heat pipe 13 is diffused outside the housing 12 via aeration ways 122 and 123. Hence, the aeration ways 122 and 123 function as heat collecting means which collect heat from the heat pipe 13. Accordingly, the rise in the temperature of the display panel 11 is prevented and the function of the liquid crystal display 10 can be maintained in a good state.

In this embodiment, since the heat pipes 13 are arranged at predetermined intervals at the back 111 of the display panel 11, heat can be collected from the whole path part, and can be collected from the whole back 111 side of a liquid crystal display. This enables the cooling efficiency of the display apparatus 1 to be high.

The temperature in the accommodation part 121 becomes higher than the temperate outside the accommodation part (i.e. aeration ways 122 and 123) when the display panel 11 generates heat. Additionally, coolant for heat exchange (e.g., fluid such as water) is placed inside the heat pipe 13. Therefore, from a view of raising the heat exchange efficiency of the heat pipe 13, it is desirable to arrange the heat pipes 13 so that they extend obliquely upward toward the aeration way 122 or 123 from inside of the accommodation part 121 as shown in FIG.3.

The heat pipe 13 in the outer side portion is arranged at a higher position than its inner side portion. By the heat from the display panel 11, the coolant in the inner side heat pipe 13 evaporates, and easily rises above toward the outer side. In the outer side portion, since the heat is deprived from the coolant by an air outside the accommodation part 121, the coolant is liquefied again and then falls back lower to inner side portion of the heat pipe 13. Then the coolant is evaporated again.

Thus, the coolant inside the heat pipe 13 circulates efficiently, and the heat exchange efficiency of the heat pipe 13 is raised. Accordingly, the heat from the panel 11 collected by the heat pipe 13 is efficiently emitted outside the first accommodation part 121.

Further, in this embodiment, since the heat pipe 13 is arranged at the back 111 of the display panel 11, restrictions when arranging the heat pipe 13 at the surface 112 side (i.e. inside the path part 11a) such as reduction of the display screen 112a, enlargement of a display apparatus 1, etc. are prevented. Thus, the heat exchange efficiency in the heat pipe 13 is high even if the heat pipe 13 is arranged at the back 111 because the heat generated by the display screen 112a is led to the heat pipe 13 by the air circulating through the circulation path 92.

Further, in order to raise a heat collecting efficiency from the back side 111 of the display panel 11, each of the heat pipes 13 is arranged along the back 111, as shown in Fig.4 and Fig.8.

Further, in this embodiment, the heat pipes 13 are repeatedly arranged in predetermined intervals in the perpendicular direction as shown in FIG.3, and are extended to the inside of the aeration way 122 or 123, maintaining the distance with the adjacent heat pipe 13 at the predetermined interval. Therefore, the heat collected by the heat pipe 13 can be dissipated in a distributed manner inside the aeration way 122 and 123, and as a result, the heat exchange (or heat dissipation) efficiency of the heat pipe 13 inside the aeration ways 122 and 123 can be increased.

### Air conditioner 19

The air conditioner 19 has an evaporator 191 and a condenser 192 as shown in FIG.2, FIG.9, FIG.10, and FIG.11. Moreover, the air conditioner 19 also has a compressor which is not illustrated. The compressor is arranged at side portion of the condenser 192 under the evaporator 191 for example. The evaporator 191 cools the air circulating through the circulation path 92 and returned to the air conditioner 19. The cooled air is again sent to the circulation path 92. The compressor compresses the coolant which flows inside the evaporator 191. The condenser 192 cools the coolant having a high temperature and pressure compressed by the compressor, and generates a liquefied coolant. When the liquefied coolant flows through the evaporator 191, the evaporator 191 can cool the surrounding air.

As shown in FIG.10 and FIG.11, the evaporator 191 is arranged at the back 111 side of the display panel 11 near the undersurface 114 of the display panel 11. In other words, the evaporator 191 is arranged at the lower end part of the path part 11c, in detail a front surface side of the portion 125b as shown in Fig.11.

By arranging the evaporator 191 at the back 111 side of the display apparatus 1, the display apparatus 1 does not need to be enlarged in the height direction. Further, by arranging the evaporator 191 to the back 111 side instead of the undersurface side 114 of the display panel 11, the circulation path 92 can be shortened.

The evaporator 191 may be arranged at the lower part of the display panel 11, i.e., the undersurface 114 side of the display panel 11 instead.

Further, as shown in FIG.13, the evaporator 191 is arranged near the portion 125b of the back wall 125. Thereby, the area near the lower end of the back wall 125 is cooled with the evaporator 191. Hereafter, the portion 125b is called a "cooled portion".

As shown in FIG.10 and FIG.11, the condenser 192 is arranged in the housing 12 and outside the accommodation part 121. Specifically, the condenser 192 is arranged between a pair of aeration plates 6, 6 under the accommodation part 121 (i.e., the lower part position of the display panel 11).

Moreover, between a pair of aeration plates 6, 6, an air intake and exhaust fan is stationed (not illustrated). This fan pulls air from the vent 61 formed in one of the aeration plate 6 and sends the air into the condenser 192 then discharges the air from the vent 61 in the aeration plate 6 of the other side. Thereby, the heat exhausted from the condenser 192 can be efficiently emitted outside the housing 12.

Although by operating the above air conditioner 19, the temperature rise in the display panel 11 is suppressed, however, in a situation where the sunlight does not enter the display panel 11 such as nighttimes, the operation may make the temperature of the panel 11 extremely low, and may cause a trouble. Further, it is undesirable in view of power consumption.

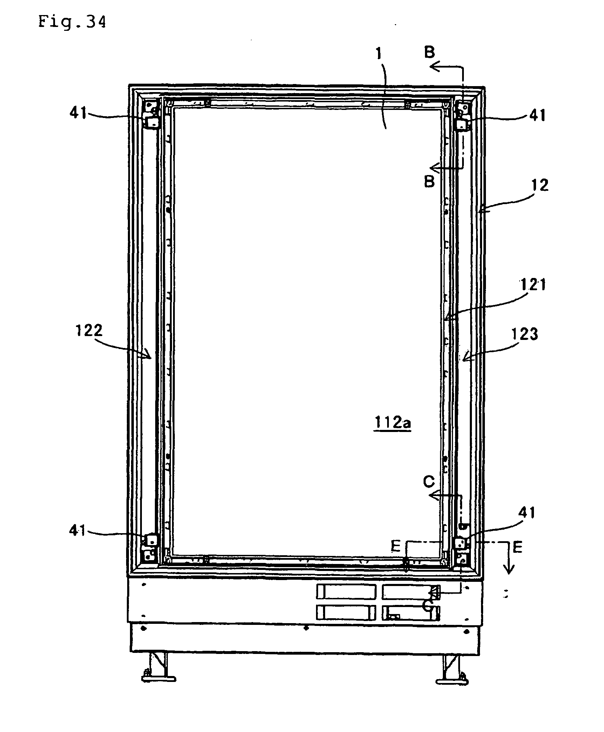

Therefore, the display apparatus 1 has a light detector 41 and the controller 42 as shown in Fig.33. And as shown in Fig.34, the light detectors 41 are arranged in every corner of the housing 12, and all of the four detectors 41 are arranged in the back side of the front wall 124, and in the position which is illuminated by the sunlight entering from the front side of the front wall 124.

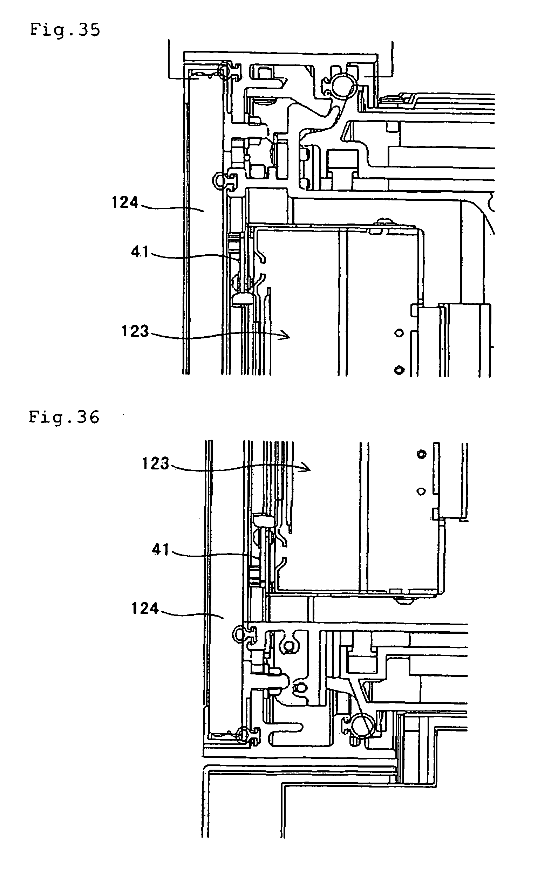

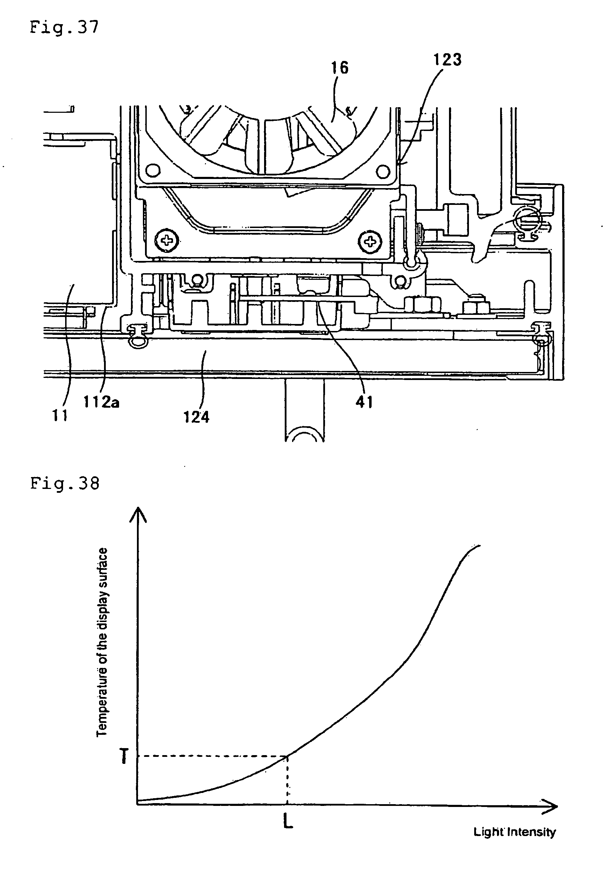

In detail, two light detectors 41 which are shown in right-hand side of Fig.34 are arranged between the aeration way 123 and the front wall 124 (see Fig.35, 36, and 37). One of them is arranged near the upper end, and the other is arranged near the lower end of the aeration way 123. The other two light detectors 41 which are shown in left-hand side of the Fig.34 are arranged between the aeration way 122 and the front wall 124, as well as those in the right-hand side. Thus, the intensity of the light entering the front wall 124 from the front side, in other words the intensity of the light entering the display panel 11 is detected by the light detector 41.

Controller 42 controls the air conditioner 19 based on the light intensity detected by the light detector 41 so that the temperature of the display panel 11 does not become too high or low. Further, since there are four light detectors 41, the controller 42 may control the air conditioner 19 based on the average value of the light intensity detected by each of the detectors 41.

For example, when the light intensity detected by the light detector 41 is larger than a predetermined value L, the controller 42 operates the air conditioner 19, and when the light intensity detected is smaller than the predetermined value L, the controller 42 stops the operation of the air conditioner 19. Here, the predetermined value L is determined based on the cooling efficiency of the air conditioner 19 or outside temperature, etc.

Further, the controller 42 may control the air conditioner 19 not only by the light intensity detected by the light detector 41 but also by the temperature in the first accommodation part 121 or outside temperature measured by a temperature sensor.

As a heat exchanging means for collecting a heat from the air inside the circulation path 92, other means may be used instead of the evaporator 191 and the condenser 192. Further, as a means for air intake and exhaust from the vent 61, other means may be used instead.

Furthermore, in this embodiment, the aeration plate 6 and the housing 12 are formed as different components, and the vent 61 is formed in the aeration plate 6. However, the vent 61 may be formed in the housing 12 without the aeration plate 6.

### Circulating fan 18,181

The circulating fans 18, 181 are fans for circulating the air in the circulation path. The circulating fan 18 is arranged at the back 111 side of the display panel 11, near the upper surface 113 of the display panel 11, as shown in FIG.10 and FIG.11. In other words, the circulating fan 18 is arranged at the upper end of the path part 11c of the circulation path 92. And the circulating fan 18 moves the air in the path part 11c to the lower portion, as shown in FIG.12.

The circulating fan 181 is arranged at the back 111 side of the display panel 11, and near the evaporator 191, in the accommodation part 121. In this embodiment, as shown in FIG.10 and FIG.11, the circulating fan 181 is arranged above the evaporator 191 in the lower end of the path part 11c, and sends an air towards the evaporator 191, as shown in FIG.13.

Thereby, the air in the circulation path 92 circulates around the display panel 11 in the direction of the solid line arrow, as shown in FIG.12 and FIG.13. Hence, by driving the circulating fan 18, 181, the air in the path part 11a can flow from the bottom up in the perpendicular direction, as shown in FIG. 12. The air then passes along the path part 11b, and flows into the path part 11c. Then the air flows downward along the path part 11c, as shown in FIG.13, and returns to the path part 11a through the path part 11d.

According to the circulating fans 18 and 181, it can lead an air in the path part 11a along the front surface 112 of the panel 11 to the path part 11c along the back 111 efficiently.

### Radiating fin 14

The radiating fin 14 is arranged in the aeration way 122, as shown in FIG.8, and is connected to the protrusion part 131 which protrudes into the aeration way 122 among the heat pipes 13. In this embodiment, the radiating fin 14 is formed by aluminum.

According to the above mentioned radiating fin 14, the heat dissipation efficiency from the heat pipe 13 to into the aeration way 122 and 123 increases, and, as a result, the cooling efficiency of the display apparatus 1 increases.

### Aeration fans 15 and 16

The aeration fans 15 and 16 are arranged in the aeration way 122, as shown in FIG.3. The aeration fan 15 is arranged at the upper end 122a of the aeration way 122, and the aeration fan 16 is arranged at the lower end 122b of the aeration way 122.

The aeration fans 15 and 16 pass the air in the aeration way 122 to the same direction along the aeration way 122. That is, the aeration fan 15 passes the air in the aeration way 122 from the bottom up, by emitting the air to the outside of the housing 12 from the vent, as shown in FIG.5. The aeration fan 16 passes the air in the aeration way 122 from the bottom up, by pulling the air outside of the housing 12 from the vent 61, as shown in FIG.6. In FIG.5 and FIG.6, the flow of the air is shown by the solid line arrows.

The aeration fans 15 and 16 are arranged in the aeration way 123 as well as in the aeration way 122 (see FIG.3), and these fans move the air in the aeration way 123 from the bottom up.

According to the above mentioned aeration fans 15 and 16, the heat emitted inside the aeration way 122 and 123 from the heat pipes 13 can be efficiently diffused outside of the housing 12. Therefore, the radiating efficiency of the heat pipe 13 and the radiating fin 14 are increased in the aeration way 122.

Further, in this embodiment, since the air in the aeration way 122 and 123 flows from the bottom up, the air can flow efficiently upwards since the warm air has a natural tendency for going up. Therefore, the heat emitted to the aeration way 122 and 123 can be efficiently diffused to the outside of the housing 12.

In this embodiment, though the aeration fans 15 and 16 are used as blowing means to exhaust the air in the aeration way 122 or 123 outside of the housing 12, other similar means may be adopted.

### Heat insulator 7

As shown in FIG.13, a heat insulator 7 is placed between the evaporator 191 and the display panel 11. In detail, the evaporator 191 is arranged at the back 111 side of the display panel 11, and the heat insulator 7 is arranged between the back 111 and the front 191a of the evaporator 191. A rubber material such as a silicon or urethane may be used as a material for the heat insulator 7.

As described above, the heat from the display panel 11 is transmitted to the evaporator 191 by an air flowing inside the circulation path 92, and is collected by the evaporator 191. According to the heat insulator 7, it can prevent an over cooling of the display panel 11 near the evaporator 191. Therefore, the temperature distribution of the display panel 11 can be uniformalized, and accordingly can keep the display panel 11 in good condition.

### Heat collecting fin 71, first blowing fan 72, and second blowing fan 73

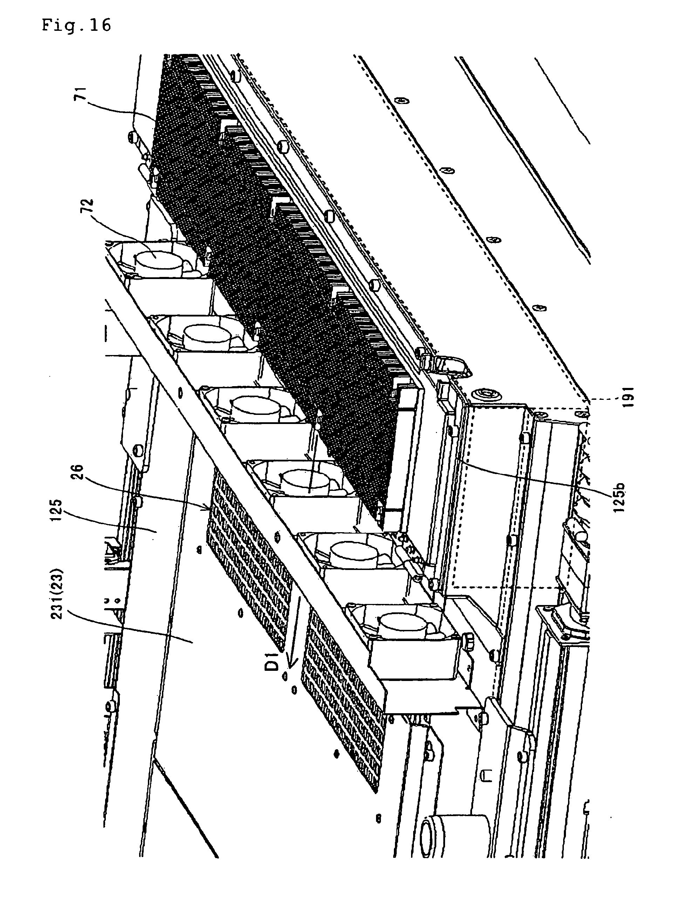

As shown in FIG.13 and FIG.16, a heat collecting fin 71 is arranged at the back side of the evaporator 191 among the back of the back wall 125. The heat collecting fin 71 functions as a heat collecting means, and it collects heat from the air in the back side of the back wall 125. Since the heat collecting fin 71 is arranged at the back side of the cooled portion 125b (which is at the back side of the evaporator 191), the heat collected by the heat collecting fin 71 is collected by the evaporator 191, and thereby the back side air of the cooled portion 125b is cooled efficiently.

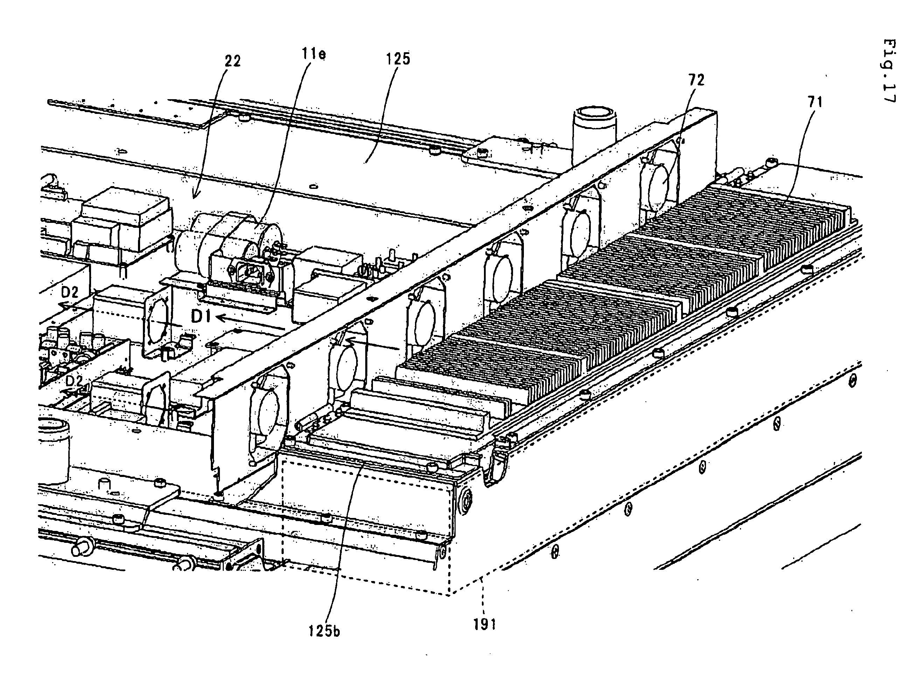

Further, as shown in FIG.13 and FIG.17, the first blowing fan 72 is arranged at the back of the back wall 125 near the upper part of the heat collecting fin 71. The first blowing fan 72 functions as a blowing means, and passes the air in the back side of the back wall 125 to the back side of the cover component 23 consisting the back wall of the second accommodation part 22. The first blowing fan 72 is arranged at the back side of the cooled part 125b and above the heat collecting fin 71. As shown by an arrow D1 of FIG.17, the first blowing fan 72 blows air up in the perpendicular direction.

Since the cooled portion 125b and the cover component 23 are aligned in substantially perpendicular direction (see Fig.11 and Fig.13), the air in the back side of the cooled portion 125b (i.e. the air cooled by the evaporator 191) is lead to the back side of the cover component 23 only by blowing the air in perpendicular direction by the first blowing fan 72.

Thereby, the rise in heat of a circuit board 11e arranged in the second accommodation part 22 is suppressed.

Further, in effort of the heat collecting fin 71, much cool air is can be led to the back side of the cover component 23, and thus the second accommodation part 22 is further cooled.

As shown in Fig.15 and Fig.17, the second blowing fan 73 is arranged at the back side of the back wall 125 of the second accommodation part 22. The second blowing fan 73 functions as a blowing means, and generates the flow of the air inside the second accommodation part 22.

As shown in Fig.15, three blowing fans 73 are arranged inside the second accommodation part 22, and all of the fans blow the air from the bottom up as shown in arrows D2 of Fig.15. Thereby, the air inside the accommodation part 22 can flow from the bottom up, as shown in Fig.11.

As mentioned above, ventilation openings 26 and 27 are formed in the lower part and the upper part cover component 23 respectively. By operating the second blowing fan 73, air in the second accommodation part 22 flows from the opening 26 to the opening 27 as shown in Fig.11.

Therefore, a cold air is inhaled from the opening 26, and the heat from the circuit board 11e is emitted from the opening 27.

Further, since the air cooled by the evaporator 191 is led to the back side of the cover component 23 by the first blowing fan 72, the cooled air is inhaled inside the second accommodation part 22 from the ventilation opening 26, and thus the circuit board 11e is cooled.

Therefore, according the heat collecting fin 71, the first blowing fan 72, and the second blowing fan 73, the temperature rise in the circuit board 11e is inhibited. Thus a heat trouble in the circuit board is reduced.

Although the heat collecting fin 71 is used as a heat collecting means, and blowing fans 72, 73 are used as blowing means for cooling the circuit board 11e, other means may be used instead.

Instead of leading the air in the back side of the cooled portion 125b to the back side of the cover component 23 by the first blowing fan 72 as described above (see Fig.16), the air in the back side of the cover component 23 may be lead to the back side of the portion 125b by the fan 72. In this case, the air inside the second accommodation part 22 is flown from the top down. Thereby, the heat from the circuit board 11e is led to the back side of the portion 125b and cooled by the heat collecting fin 71 and the evaporator 191.

Further, the first blowing fan 72 may be arranged under the heat collecting fin 71, instead of above the fin 71.

### 3. Composition for attaching the display apparatus to the support stand

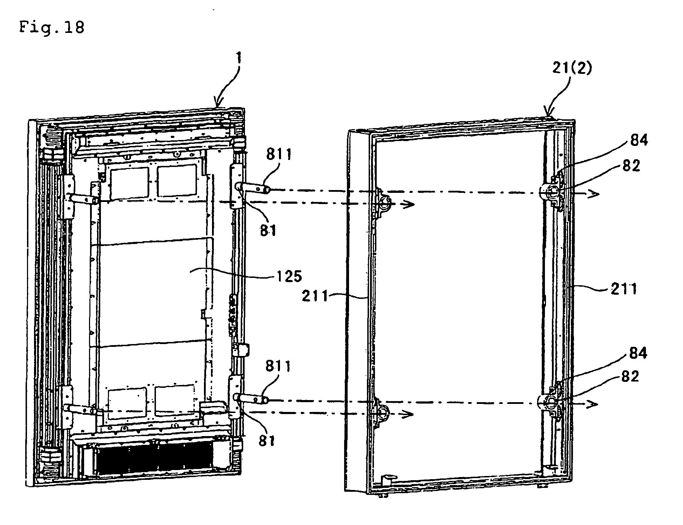

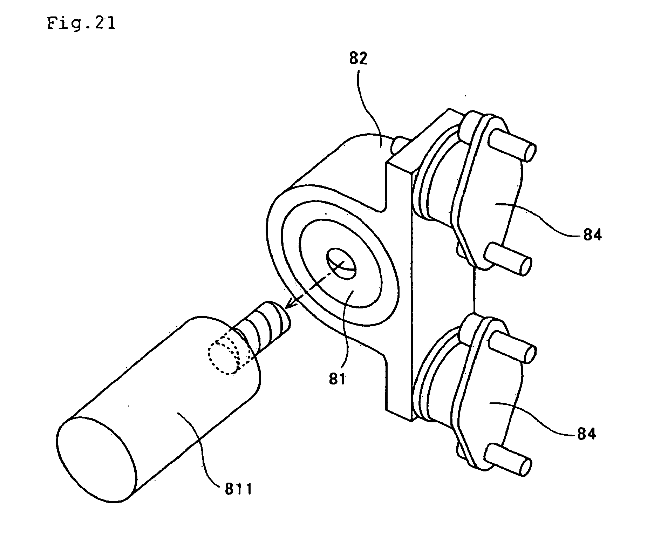

As shown in FIG.18, a pole-shaped engaging component 81 which protrudes from the back of the display apparatus 1 is attached on the back of the display apparatus, and an extended component 811 for enlarging the protrusion from the back of the display apparatus 1 is removably attached on the tip of the engaging component 81. In detail, a screw is formed in the base of the extended component 811 while a screw hole is formed in the tip of the engaging component 81, and by engaging the screw with the screw hole, the extended component 811 is attached at the tip of the engaging component 81 (see FIG.21).

In this embodiment, four engaging components 81 are arranged at the back of the display apparatus 1, and these engaging components 81 are attached to both side edges two by two, one on the top and the other on the bottom.

Further, as shown in FIG.22, a pair of side wall parts 211,211 of the frame part 21 has a ring like engaged component 82 attached on its inner circumference through the elastic rubber component 84. Here, the engaged component 82 is engaged to the engaging component 81 attached to the display apparatus 1. In this embodiment, as shown in FIG.22, four engaged components 82 are attached to the side wall parts 211,211 corresponding to each of the four engaging components 81 attached to the display apparatus 1.

When attaching the display apparatus 1 to the support stand 2, first, the extended component 811 attached on the engaging component 81 is inserted into the corresponding engaged component 82 from the tip, as shown in FIG.21 and FIG.23. Then, the display apparatus 1 is pushed into the frame part 21.

Thereby, the engaging component 81 is guided to the engaged component 82 by the extended component 811, and fits into the engaged component 82. As a result, the engaging component 81 and the engaged component 82 are engaged in a condition where the display apparatus 1 is inserted to the frame part 21. Thus, the extended component 811 assists the insertion (or fitting) of the engaging component 81 to the engaged component 82.

After the engaging component 81 is fitted to the engaged component 82, the extended component 811 is removed as shown in FIG.24. And as shown in FIG.25, the engagement sustaining component 83 is attached to the tip part of the engaging component 81 fitted to the engaged component 82 in a detachable form. In detail, a screw is formed in the engagement sustaining component 83, and engaging the screw with a corresponding screw hole formed in the engaging component 81, the engagement sustaining component 83 is attached at the tip of the engaging component 81.

When engagement sustaining component 83 is attached to the tip of the engaging component 81, it contacts the opening end side 82a of the engaged component 82. Thereby, the engaging of the engaging component 81 and the engaged component 82 is held by the engagement sustaining component 83.

According to the above mentioned structure, a position of the display apparatus 1 when inserted to the frame part 21 can be fixed only by engaging the engaging component 81 and the engaged component 82. Therefore, the positioning of the display apparatus 1 can be simplified. Further, by sustaining the engagement of the engaging component 81 and the engaged component 82 by the engagement sustaining component 83, the display apparatus 1 can be fixed to the support stand 2.

Further, in this embodiment, since the engaged component 82 is attached to the frame part 21 through the elastic component 84, even if a vibration is added to a display system, this vibration is absorbed by the elastic component 84.

Therefore, transfer of the vibration to the display apparatus 1 from the frame part 21 can be prevented, and a breakage of the display apparatus 1 by vibration can be prevented.

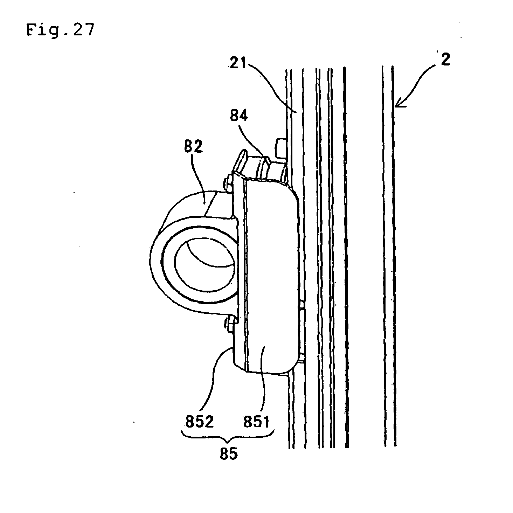

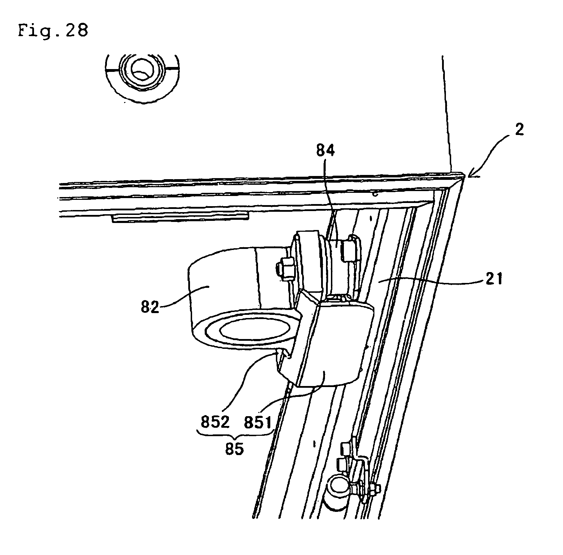

Preferably, the prevention component 85 having L-shaped structure may be fixed to the engaged component 82 as shown in Fig.27 and Fig.28. In this case, the prevention component 85 has a first flat plate 851 and a second flat plate 852 which are connected L-shaped, and the second flat plate 852 is screwed to the engaged component 82 so that the first flat plate 851 overlaps the back of the frame part 21. Further, the prevention component 85 is fixed to the engaged component 82 so that it does not deteriorate the absorbing function of the elastic component 84.

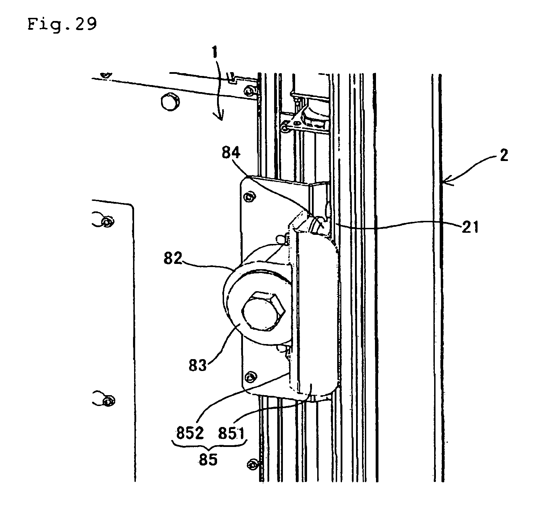

According to the composition such that the prevention component 85 is fixed to the engaged component 82 as described above, by securing the engagement of the engaging component 81 and engaged component 82 by the holding component 83 as shown in Fig.29, the prevention component 85 is connected to the display apparatus 1.

Therefore, even if the elastic component 84 become depleted and the display apparatus 1 cannot be fixed to the frame part 21, since the first plate 851 of the prevention component 85 contacts with the back of the frame part 21, it can prevent the display apparatus 1 from falling forward.

Further, since fluorescent light fittings 5, and backboard 3 are arranged at the back side of the display apparatus 1, even if the display apparatus 1 is inadvertently released from the frame part 21, it can prevent the apparatus 1 from falling to the back side.

The present invention is not limited to the foregoing embodiment but can be modified variously within the scope of the appended claim. For example, the technology mentioned above is applicable not only to the liquid crystal displays, but also to the other plane-surface type displays, such as plasma displays, or organic electroluminescence (Electro-Luminescence) displays.

## Claims

1. A display system comprising:
a display apparatus (1);
a frame part (21) surrounding the display apparatus;
**characterized by** further comprising:
an engaging component (81) arranged on the display apparatus (1);
an engaged component (82) connected to the frame part (21) via an elastic component (84) and engaged to the engaging component (81), and
a preventing component (85)
having a first portion (851) arranged so as to overlap the back of the frame part (21) and a second portion (852) connected to the first portion and fixed to the engaged component (82), so that
the first portion (851) prevents the display apparatus (1) from falling ahead with respect to the frame part (21).

## Patentansprüche

1. Anzeigesystem, umfassend:
eine Anzeigevorrichtung (1);
ein Rahmenteil (21), das die Anzeigevorrichtung umgibt;
**dadurch gekennzeichnet, dass** es ferner umfasst:
eine eingreifende Komponente (81), die an der Anzeigevorrichtung (1) angeordnet ist;
eine Eingriffskomponente (82), die mit dem Rahmenteil (21) mittels einer elastischen Komponente (84) verbunden ist und mit der eingreifenden Komponente (81) in Eingriff ist, und
eine Verhinderungskomponente (85) mit einem ersten Abschnitt (851), der derart angeordnet ist, dass er die Rückseite des Rahmenteils (21) überdeckt, und mit einem zweiten Abschnitt (852), der mit dem ersten Abschnitt verbunden ist und an der Eingriffskomponente (82) befestigt ist, so dass der erste Abschnitt (851) ein Herausfallen der Anzeigevorrichtung (1) nach vorne bezogen auf das Rahmenteil (21) verhindert.

## Revendications

1. Dispositif d'affichage comprenant :
un appareil d'affichage (1) ;
une partie de châssis (21) entourant ledit appareil d'affichage ;
**caractérisé en ce qu'**il comprend, en outre :
un composant de couplage (81) agencé sur l'appareil d'affichage (1) ;
un composant couplé (82) relié à la partie de châssis (21) par l'intermédiaire d'un composant élastique (84) et couplé au composant de couplage (81), et
un composant de prévention (85) comportant une première partie (851) agencée de manière à recouvrir l'arrière de la partie de châssis (21) et une seconde partie (852) couplée à la première partie et fixée sur le composant couplé (82), de telle sorte que
la première partie (851) empêche l'appareil d'affichage (1) de tomber vers l'avant par rapport à la partie de châssis (21).
